Europäisches Patentamt

European Patent Office

Office européen des brevets

(11) Veröffentlichungsnummer: **0 385 382**
**A2**

## (12) EUROPÄISCHE PATENTANMELDUNG

(21) Anmeldenummer: 90103766.3

(22) Anmeldetag: 27.02.90

(51) Int. Cl.5: **C30B 31/00**

(30) Priorität: 27.02.89 DE 3906075

(43) Veröffentlichungstag der Anmeldung:
05.09.90 Patentblatt 90/36

(84) Benannte Vertragsstaaten:
**AT BE CH DE DK ES FR GB GR IT LI LU NL SE**

(71) Anmelder: **Söhlbrand, Heinrich Dr.,**
**Wirtsbauernstr. 26**
**D-8027 Neuried b. München(DE)**

(72) Erfinder: **Söhlbrand, Heinrich Dr.,**
**Wirtsbauernstr. 26**
**D-8027 Neuried b. München(DE)**

(54) **Verfahren zur thermischen Behandlung von Halbleitermaterialien und Vorrichtung zur Durchführung desselben.**

(57) Mit der Erfindung wird ein Verfahren und eine Vorrichtung vorgeschlagen, die zur thermischen Behandlung von Halbleitermaterialien dienen, wobei die Strömung der Prozessgase in einem vakuumdichten, isothermalen, vertikal angeordneten Prozessraum gesteuert wird indem diese durch seitlich in der Prozessrohrwand vorgesehene Lochreihen in den Prozessraum einströmen und die zu behandelnden Halbleiterscheiben oder dergl. schräg auf einem während des Verfahrensablaufes rotierenden Drehtisch angeordnet sind, wobei variable Spülgasmengen die sogen. "schnelle Kassette" ermöglichen und Schichten zwischen 2,0 und 10,0 nM erzielt werden können, Start- und Endtemperatur bis Raumtemperatur möglich sind, auch Einscheibenprozesse gefahren werden können, und sämtliche Prozesse bei nahezu toleranzfreier Reproduzierbarkeit ablaufen.

Fig. 1

# VERFAHREN ZUR THERMISCHEN BEHANDLUNG VON HALBLEITER-MATERIALIEN UND VORRICHTUNG ZUR DURCHFÜHRUNG DESSELBEN

Die Erfindung bezieht sich auf ein Verfahren zur thermischen Behandlung von Halbleitermaterialien bei dem man die zu behandelnden Halbleiterscheiben oder dergl. Prozessgasmischungen unterschiedlicher und wechselnder Zusammensetzung und Temperatur aussetzt und einer Vorrichtung zur Durchfuhrung des Verfahrens, die einen vertikal angeordneten Prozessraum mit einem einseitig offenen Prozessrohr und einer zylindrisch das Prozessrohr umfassenden Heizkassette aufweist in dem die zu behandelnden Halbleiterscheiben auf einem Träger angeordnet sind sowie einer in einem das Prozessrohr umfassenden Ringraum vorgesehenen Fluidspülung.

Vorrichtungen zur Durchfuhrung solcher Verfahren sind allgemein auch unter dem Begriff "Diffusionsofen" bekannt.Sie bestehen im wesentlichen aus einem Prozessrohr mit einer Heizkassette umgeben und der Beschicksungseinrichtung, meist ein sogen. Cantileversystem. Solche Diffusionsöfen sind meistals Horizontalöfen im Einsatz, d.h. das Prozessrohr ist hortizontal angeordnet und wird von vorn mit mit den zu behandelnden Halbleiterscheiben beschickt. Es sind auch Vertikalöfen bekannt, bei denen das Prozessrohr vertikal angeordnet ist ·und die von unten oder von oben mit den Halbleiterscheiben beschickt werden. Die bekannten Vertikalöfen bestehen im wesentlichen aus dem vertikal angeordneten Prozessrohr, das von einer Heizkassette herkömmilcher Bauart umschlossen ist. Die Halbleiterscheiben sind in dem Prozessrohr in einer hängenden oder stehenden Horde in Prozessbedingten Abständen senkrecht übereinander geschichtet, jedoch horizontal ausgerichtet. Sie werden in dem Prozessrohr einer Wärmebehandlung mit unterschiedlichen Prozessgasen ausgesetzt, die den Reaktionsraum von unten nach oben durchströmen. Der Reaktionsraum ist an seinem offenen Ende, unten oder oben, mittels lose angelegter Verschlußelemente mit integriertem Gaszu-und ableitungen weitgehend gegen die umgebende Reinraumatmosphäre abgedichtet. Dabei wird bei der Durchführung des Verfahrens, das der Vorrichtung angepasst ist, mit Gasverdrängungsspülung gearbeitet.

Die Nachteile solcher Vorrichtungen und dar in durchgeführten Verfahren liegen auf der Hand. Insbesondere die systemimmanenten Technologie-Nachteile sind es, die die Ausbeute nachteilig beeinflussen, so u.a. die undefinierte Gasatmosphäre sowie regelmässig auftretende Rückdiffusion, die eine Reproduzierbarkeit der Prozessparameter und damit des Verfahrensergebnisses von Charge zu Charge unmöglich machen. Weitere technologische Nachteile sind die nicht erreichbare Isothermie im Reaktionsraum, nicht vorhandene vakuumdichte Trennung des Reaktioinsraumes von der Außenwelt und eine mit erheblichen Mängeln behaftete Gasströmung, die durch Thermik, Konvektion und Laminarität charakterisiert ist. Schließlich sind die bekannten Verfahren und Vorrichtungen dieser Art unwirtschaftlich, weisen einen großen Materialverschleiß auf und unterliegen einem hohen Bruchrisiko.

Hier will die Erfindung Abhilfe schaffen. Die Erfin dung, wie sie in den Ansprüchen gekennzeichnet ist, löst die Aufgabe, die oben geschilderten Nachteile mit Sicherheit zu vermeiden und ein Verfahren sowie eine Vorrichtung zur Durchführung des Verfahrens zu besitzen, die an das Verfahren angepasst ist und in der der Gasfluß innerhalb des Reaktionsraumes steuerbar ist.

Mit der Erfindung werden mehrere Vorteile gleichzeitig erzielt. Durch die Einflußnahme auf die Prozessgas-Strömung innerhalb des Prozessrohres, also im Reaktionsraum wird die Ausbeute nicht nur verbessert, sondern die Prozessbedingungen und damit die Reproduzierbarkeit derselben ist gegeben. Insbesondere sind die Gasströme durch die Anordnung der Verwirbelungs-Düsen in der Wand des Prozessrohres nicht mehr, wie bisher, stets auf die gleiche Stelle der zu behandelnden Halbleiterscheiben gerichtet, sondern sie treffen in immer wechselnden Winkeln, auf die Oberfläche der Halbleiterscheiben verteilt, auf. Außerdem ist durch die Schräglage der Haibleiterscheiben auf der Horde gewährleistet, daß sich keine unerwünschten Gaskonzentrationen an bestimmten Teilen der Oberfläche derselben bilden. Ein weiterer Vorteil ist die übergeordnete Flußrichtung der Gasströme von oben nach unten, d.h. das Gas wird unten aus dem Prozessraum entfernt und kann sich nicht oben oder an sonstigen Stellen sammeln. Der Einsatz von inerten Spülgasen zur Verhinderung jedwelcher Kontamination aus dem Bereich der Heizkassette ist ein weiterer Vorteil. Somit können keine molekularen oder atomaren Verunreinigungen in den Reaktionsraum gelangen. Die wirksame Kühlung durch Spülgase im Mantel- und Zwischenraum trägt zu raschem Chargenwechsel und damit wirtschaftlicher Durchführung des Verfahrens bei. Die dazu notwendige Vorrichtung ist den Verfahrensbedingungen angepasst und weist außer einem Mehrrohrsystem, bestehend aus einem inneren und einem äußeren Reaktionsrohr, insbesondere einen während des Verfahrensablaufes rotierenden Drehtisch für die zu behandelnden Halbleiterscheiben, an der Wand des inneren Prozessrohres vorgesehene Verwirbelungsdüsen für die Einleitung der Prozessgase in den Prozessraum auf.

Das Systemdesign weist darüberhinaus den Vorteil auf, auch besonders für die Durchführung von Verfahren der Wärmebehandlung von wenigen oder nur einer einzigen Halbleiterscheibe, auch sehr großen, (Ein-Scheiben-Prozesse, bzw. Cassette-to-cassette-Ein-Scheiben-Prozeß) geeignet zu sein.

Die Erfindung ist nachstehend anhand der in den Abbildungen dargestellten Ausführungsbeispiele näher erläutert.

Es zeigt:

Figur 1 einen Längsschnitt durch eine erfindungsgemäße Vorrichtung,

Figur 2 eine Ausführungsvariante der Figur 1,

Figur 3 eine weitere Ausführungsvariante,

Figur 4 einen kompletten Diffusionsofen und

Figur 5 eine Ausführungsvariante des Diffusionsofens.

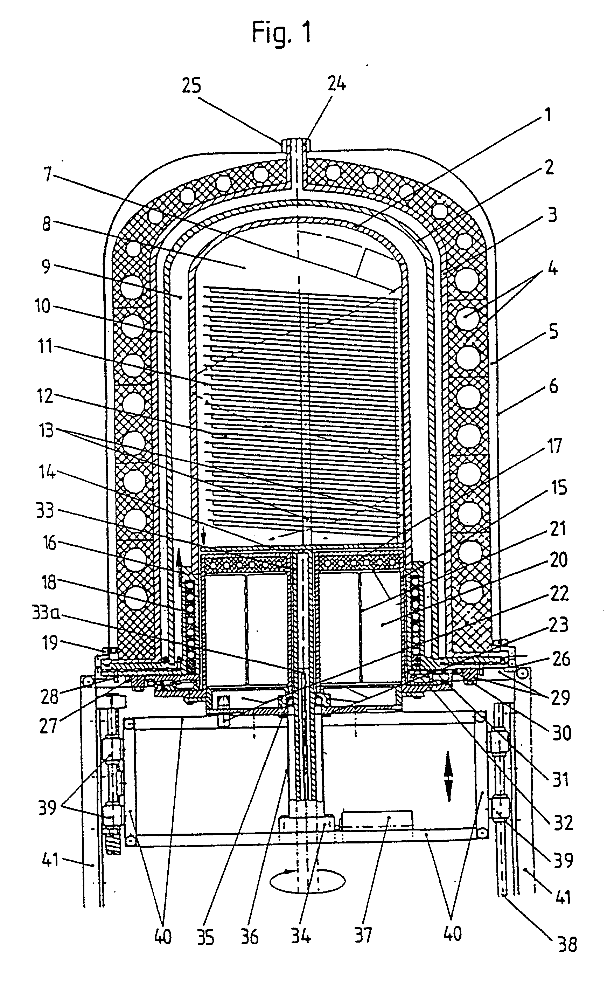

Die in Figur 1 dargestellte Vorrichtung stellt den Hauptbestandteil eines sogen. Diffusionsofens dar, nämlich die eigentliche Prozesseinheit, die im wesentlichen aus dem inneren Prozessrohr 1, dem äußeren Prozessrohr 2, die vorzugsweise aus Quarz gefertigt sind, dem Mantelrohr 3, beispielsweise aus Keramik, der Heizkassette 4 mit den weiteren Heizelementen 17 und 18 sowie dem Reaktionsraumverschlußsystem 15 und dem Drehtisch 14 besteht.

Die etwa glockenförmige Heizkassette 4 wird nach außen noch von der Haube 6 umfaßt. Diese Haube 6 besitzt an ihrem oberen Ende eine Öffnung für den Spülgasauslaßstutzen 24 und den Kühlgasauslaßstutzen 25 der Heizkassettenmantel-Kühlung 5.

In dem Hohlraum 9, dem sogen. Prozessgas-Zwischenraum, befindet sich strömendes Prozessgas stets unter einem geringen Überdruck, um eine gute Verteilung der Prozessgasmischung bereits vor dessen Einblasen in den Reaktionsraum 8 zu erzielen. Das Prozessgas wird durch mindestens eine Lochreihe 7 in den inneren isothermalen Reaktionsraum 8 derart eingebracht, daß darin die auf dem Drehtisch 14 d.h. dessen Scheibenträger 13 mit seinen Scheibenaufnahmen 12 befindlichen Halbleiterscheiben 11 allseits von dem Prozeßgas umspült werden. Die Lochreihe-n 7 ist/sind daher vorzugsweise schraubenförmig mit unterschiedlicher Steigung und unbestimmter Lochanzahl in der Wand des inneren Reaktionsrohres 1 vorgesehen, wobei die Durchmesser der Löcher etwa 0,5 mm oder größer sind und die räumliche Achse der Löcher bezogen auf die zentrale Rohrachse desorientiert ist. Die Halbleiterscheiben 11 sind dabei auf der Scheibenaufnahme 12 in leicht geneigter Anordnung übereinander geschichtet, sodaß während der Behandlung deren gesamte Oberfläche dem Gasstrom aus der, bzw. den Lochreihen 7 ausgesetzt ist. Eine Charge besteht dabei aus einer typischen Losgröße von 25 Halbleiterscheiben 11 zuzüglich einiger Dummies. Bei unkritischen Prozessen können auch mehr Halbleiterscheiben gleichzeitig eingefahren und behandelt wer den.

Die Prozessgasmischung wird durch den Einlaßstutzen 28 in den Prozessgas-Zwischenraum 9 eingebracht und durch das Prozessgas-Auslaßrohr 30 wieder aus dem System entfernt.

Zwischen dem äußeren Reaktionsrohr 2 und dem die Heizkassette 4 tragenden Keramikrohr 3 ist ein äußerer ringförmiger Spülraum 10 vorgesehen, der in sogen. "low-flow-mode" oder "high-flow-mode" mit Spülgas durchströmt wird, um einerseits in "low-flow-mode" mit wenigen Litern Spülgas pro Minute zu verhindern, daß der Reaktionsraum durch Bestandteile der Heizkassette 4 contaminiert wird und andererseits in "high-flow-mode" eine rasche Abkühlung erreicht werden kann. Auf diese Weise wird nämlich das Gesamtsystem auf Temperaturen deutlich unter die bisher üblichen stand-by Temperaturen von 700° bis 800° C schnell abgekühlt. Es sind damit stand-by Temperaturen von 300° C und darunter (bis Raumtemperatur) erzielbar, d.h. die sogen. "schnelle Heizkassette" ist damit verwirklicht. Zwischen dem Außenmantel der Heizkassette 4 und der Haube 6 befindet sich ein weiterer Kühlraum 5, der die Heizkassette 4 umgibt und an seiner Basis mindestens einen tangentialen Einblasstutzen 19 für die Mantelkühlung besitzt, die, nach Durchströmen des Kühlraumes 5, diesen durch den Stutzen 25 wieder verlässt. Die als Heizkassettenummantelung dienende Haube 6 ist reinraumtauglich ausgebildet, wozu sich u.a. Edelstahl gut eignet.

Unterhalb des Reaktionsrohres 1 befindet sich ein Prozessgasvorwärmer 16, der als zylindrischer, doppelwandiger Ring mit breitem Flansch ausgebildet ist und das Reaktionsrohr 1 trägt. In diesen Ring ist ein Heizelement 18 integriert sowie ein oder mehrere Prozeßgaseinlaß- und -auslaß-Stutzen 28 bzw. 30. Für eine rasche Systemabkühlung ist außerdem mindestens ein Gaseinlaß-Stutzen 27 für Spülgas vorgesehen. Das Heizelement 17, unterhalb des Reaktionsrohres 1 im Reaktionsraumverschluß-System 15 angeordnet, wird von einem Stützring 21 getragen.

Der Prozessgasvorwärmer 16 enthält ein zylindrisches Heizelement 18 und besitzt in seinem als Flansch ausgebildeten Kragen ein oder mehrere Prozeßgaseinlaßkanäle 28. Der von dem Reaktionsraumverschlußsystem 15, unterhalb des scheibenförmigen Heizelementes 17 befindliche topfförmige Hohlraum 20 ist mit Quarz-, Steinwolle oder dergl. eingefüllt. Das Stützrohr 21 ist auf der Tragrohrlagerschale 22 mit integrierter Kühlung aus hitzebeständigem, schmierstoffreien Material, wie z.B. Keramik angeordnet, wobei die Luftkühlung das Lager 35 aus Keramik oder Metall oder Kunststoff kühlt. Mit 26 ist eine Flanschverbindung bezeichnet.

Das gesamte System 1 bis 28 wird von einer gemeinsamen Montagevorrichtung 29 getragen, an die auch ein Wasserkühlungskanal 31 und Luftkühlungskanal 32 angeflanscht sind.

Das koaxiale Tragrohr 33 des Turntables 14 ist innen mit einem Luftkühlrohr 33a versehen. Dieses Tragrohr 33 ist in den Lagern 34 und 35 gelagert. Eine Inertgasspülung ist in dem Schutzrohr 36 vorgesehen und besitzt eine Absaugeinrichtung mit einem Mehr-Wege-Ventil.

Der Antrieb 37 des Turntables 14 ist in dem Rahmen 40 angeordnet, der das von unten in die Reaktionsrohreinheit einfahrbare System trägt und in Lagern 39 auf dem Schienensystem 38 geführt ist. Das Schienensystem 38 ist an dem Gestell 41 befestigt.

Das mit 15 bezeichnete, zylindrisch ausgebildete, Verschlußsystem des Reaktionsraumes hat eine Mehrfachfunktion. Zunächst dient es dazu, den Reaktionsraum 8 beladeseitig, also von unten, vakuumdicht zu verschließen. Es trägt das regelbare Heizelement 17, welches zur Erhaltung der Isothermie erforderlich ist und durch den Stützring 21 in der dargestellten Position fixiert ist. Das Verschlußsystem 15 besteht vorzugsweise aus halbleitertauglichem Material, beispielsweise aus Quarz, Poly-Silizium, SiC oder anderen Keramikmaterialien, die sämtlich bis weit über 1300°C formstabil sein müßen.

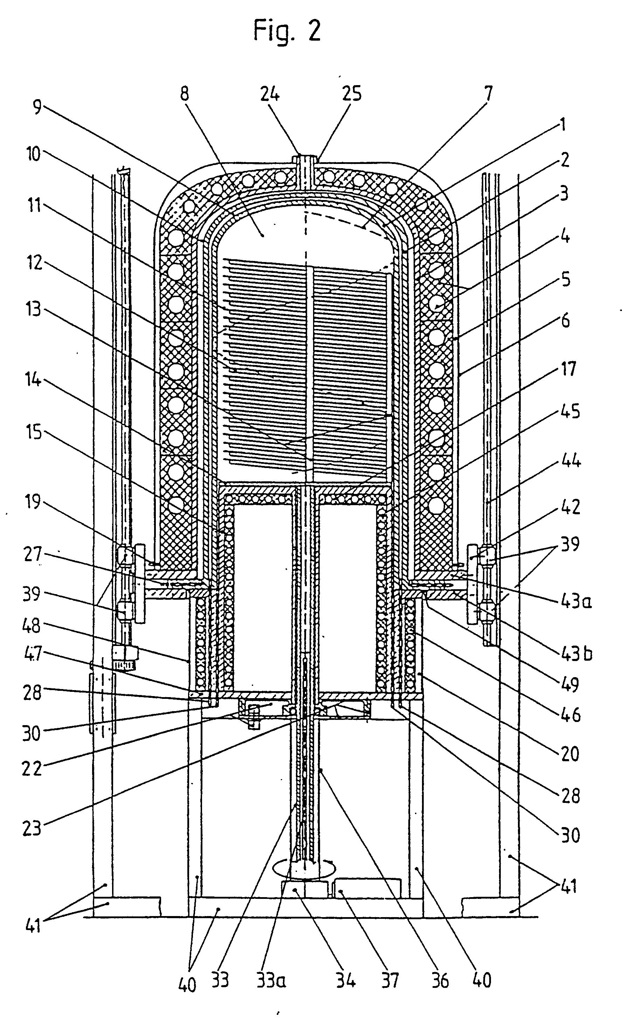

Während gem. Figur 1 der Turntable 14 mitsamt dem Verschluß-System des Reaktionsraumes 8 nach der Beladung mit Halbleiterscheiben 11 von unten in das stationäre Reaktionsrohr 1 eingefahren wird, sieht die in Fig.2 dargestellte Ausführungsvariante vor, daß die komplette Reaktionseinheit, bestehend aus dem inneren Reaktionsrohr 1, dem äußeren Reaktionsrohr 2, dem Mantelrohr 3, der Heizkassette 4 mit der Haube 6 sowie den Zu- und Ableitungen 27 für das Spülgas und die Mantelkühlung 5 nach oben gefahren wird, während der Turntable 14 stationär verbleibt. Dazu ist das Verschluß-System des Reaktionsraumes 15 wieder in dem Rahmen 40 gehalten und das Gestell 41 für das Schienensystem 44 seitlich angeordnet. Eine Halteplatte 42 mit zwei Ringflanschen trägt die bewegliche Reaktionseinheit und gleitet über die Gleitlager 39 an den Holmen des Schienensystems 44. Mit 43a ist der obere und mit 43b der untere Ringflansch bezeichnet.

Ein innerer, regelbarer Heizzylinder 45 ist unterhalb des Turntables 14 vorgesehen. Die Vorwärmung der Prozeßgase gem. Fig.2 wird durch die Anordnung der Heizelemente 45 und 46 und der im Verschluß-System 15 des Reaktionsraumes 8 vorgesehenen Prozeßgasein- und -auslässe 28 und 30 gewährleistet. Die Abschlußplatte des Rohrverschlußsystems ist mit 47 bezeichnet. Diese trägt die regelbaren Heizelemente 17, 45 und 46, derartig angeordnet, daß die von unten einströmenden Prozeßgasae vorgewärmt werden und ein Kondensieren nach unten ausströmender Abgase im Gesamtsystem verhindert wird. Verbleibende Hohlräume sind mit Quarzwolle innerhalb des Mantels 48 ausgefüllt um die notwendige Wärmedämmung zu gewährleisten. Schließlich ist noch eine ringförmige Dichtung 49 mit Fluidkühlung vorgesehen.

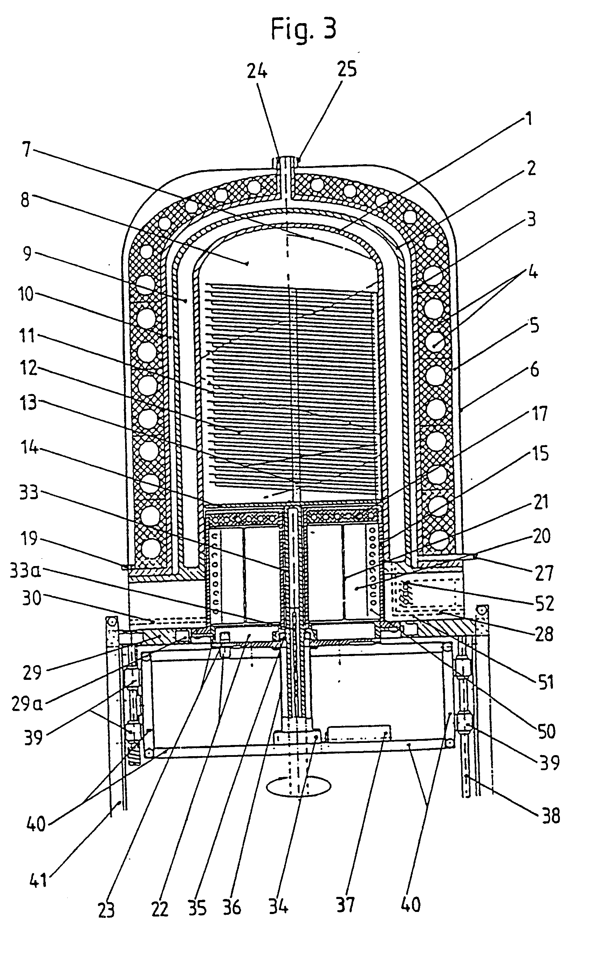

Eine weitere Ausführungsvariante ist in Figur 3 dargestellt. Sie zeigt insbesondere eine andere Ausbildung des Prozessgasvorwärmers 16 gem. Figur 1, bzw. 17, 45 und 46 gem. Figur 2.

Der Prozeßgasvorwärmer gem. Figur 3 besteht aus dem zylindrischen Heizelement 50 und einem U-profilförmigen Ringflansch 51, der ggf. auch aus einzelnen Segmenten zusammengesetzt sein kann und einem Heizelement 52. Dieses Heizelement 52 kann sowohl aus einzelnen, stabförmigen, einen Ring bildenden einzelnen Heizelementen gebildet sein, als auch aus einer Heizschlange, die um den U-profilförmigen Flansch 51 gewickelt ist, oder aus einzelnen einschiebbaren Heizelementsegmenten, die dem U-profilförmigen Ringflansch 51 angepaßt sind. Eine solche Anordnung der Heizelemente 50 und 52 ermöglicht einen raschen Austausch und eine einfachere Anpassung an unterschiedliche Prozessparameter.

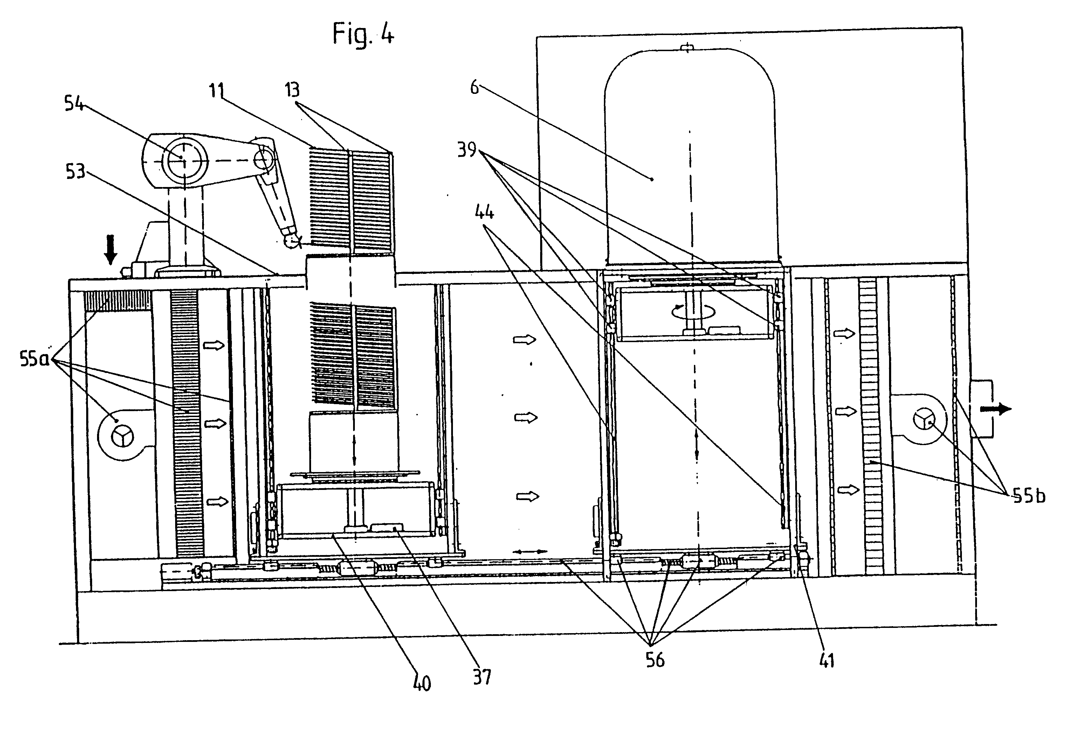

Die Figur 4 zeigt die Seitenansicht eines Diffusionso fens mit vertikaler, stationärer Reaktionseinheit und nach unten beweglichem Turntable 14.

Auf einem Reinraumtisch 53, außerhalb der eigentlichen Reaktionseinheit, wie in Fl g. 1 beschrieben, ist ein Roboter 54 montiert, der den Turntable 14 automatisch be- und entläd. Der Turntable 14 wird dazu -links oben im Bild- mit Halbleiterscheiben 11 beladen und, nach Absenkung mittels der Verschiebeeinrichtung 56 nach rechts verfahren, um nach rechts und aufwärts in das Reaktionsrohr 1 einzufahren. Mit 55a und 55b sind Gebläse bezeichnet, incl. Filtereinheiten, um zu sicher zustellen, daß während der Auf- und Ab- sowie Translationsbewegungen im Tunnel unter dem Reinraumtisch 53 die Scheiben ausschließlich in Reinraumluft der Klasse 1-5 bewegt werden.

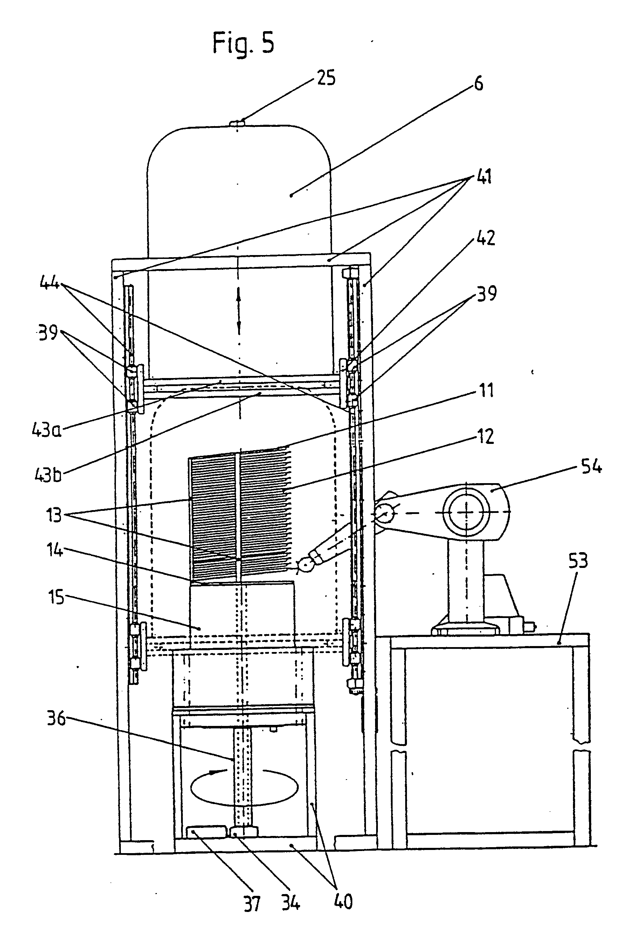

Figur 5 zeigt einen Diffusionsofen gem. Figur 2 mit stationärem Turntable 14 und nach oben beweglicher Reaktionseinheit. Zur Be- und Entladung wird die Reaktionseinheit angehoben, damit der Roboter 54 die Halbleiterscheiben 11 in den Turntable 14 einbringen, bzw. aus diesem entfernen kann.

Der Prozessablauf in dem Reaktionsrohr 1 ( Oxydation, H -Tempern, Diffussion, Deposition ) ist wie folgt:

Beispiel 1: Oxydation (anhand der Fig.4 erläutert)

Zunächst wird der innere isothermale Reaktionsraum 8 auf Starttemperaturen zwischen Raumtemperatur und 300° C temperiert und der Turntable 14 mit Halbleiterscheiben 11 beladen, indem der Roboter 54 diese scheiben einer nicht dargestellten Lagerhorde entnimmt und in Scheibenaufnahmen 12 des Scheibenträgers 13 einlegt. Die Scheibenaufnahmen 12 sind vorzugsweise rund ausgebildet und sind bis weit über 1300° C form stabil. Ein Abrutschen der schräg gestellten Scheiben 11 wird durch einen Anschlag in der Scheibenaufnahme vermieden. Sodann fährt der Turntable 14 nach unten und anschließend nach links, um danach wieder nach oben in den Reaktionsraum 8 der Reaktionseinheit einzufahren, wie aus den Figuren 1 und 4 ersichtlich. Bei der Ausführungsvariante gem. den Figuren 2 und 5 bleibt der Turntable 14 stationär, dafür wird die Reaktionseinheit mit dem Reaktionsraum 8 angehoben, sodaß der Beladevorgang von dem Roboter durchgeführt werden kann. Nach Abschluß der Beladung wird die Reaktionseinheit wieder absenkt.

Nach Einfahren der zu behandelnden Halbleiterscheiben 11 in den inneren Reaktionsraum 8 wird zunächst ein Gasaustausch vorgenommen, wobei die zunächst weitgehend atmosphärische Zusammensetzung der Gase im Reaktionsraum 8 gegen die bereits durch den Prozessgasvorwärmer 16 erwärmte Prozeßgasmischung mittels eines "soft-pump-down" Schrittes ausgetauscht wird, d.h. durch ein- oder mehrfaches Evakuieren und Wiederfüllen mit der gewünschten Prozeßgasmischung. Der Austausch der Gase erfolgt durch den/die Prozessgaseinlaß-Stutzen 28 und das/die Prozeßgasauslaß-Rohr-e 30. Der Druck im inneren Reaktionsrohr 8 wird prozessabhängig auf die erforderlichen Werte eingestellt.

Als Prozessgasmischung eignet sich z.B. $O_2$/HCL i.V. 97/3 Vol.% sehr gut. Die Prozeßgase strömen durch den Prozeßgas-Zwischenraum 9, der konstant mit geringem Überdruck beaufschlagt ist und durch die Löcher 7 in der Wand des inneren Reaktionsrohres 1 in den inneren Reaktionsraum 8, wo sie, stets nach unten strömend, auf die Oberfläche der schräg im Gasstrom mit dem Turntable 14 rotierenden Halbleiterscheiben 11 tref fen. Indem die Heizkassette 4 und das Heizelement 17 hoch geregelt werden, steigt die Temperatur im inneren Reaktionsrohr 8 auf 800 C. Während dieser sogen. "ramping-up" Phase erfolgt eine Decontaminierung der Oberfläche und oberflächennaher Gitterplätze der Halbleiterscheiben 11, insbesondere durch die Einwirkung von Chlor. Nach einer gewissen Verweildauer bei 800 C erfolgt weiteres "ramping-up" bis auf die eigentliche Prozeßtemperatur von etwa 900 C bis 1100 C.

Jetzt wird der Zustrom von Chlorgas unterbunden und die Oxydationsphase eingeleitet, die in drei oder vier Varianten, die auch teilweise hintereinander geschaltet sein können, abläuft:

1. Einleitung von trockenem O oder
2. Einleitung von feuchtem O , O /H 1 : 1,7
3. Einleitung von trockenem O , mit Inertgas (z.B. Ar) verdünnt,
4. Einleitung von trockenem oder feuchtem O, mit oder ohne Inertgas (z.B. Ar), jedoch unter Niederdruck, d.h. die Varianten 1 bis 3, jedoch mit reduziertem Arbeitsdruck pals weiterem unabhängig variablen Prozeßparameter.

Die Varianten gem 4. eignen sich besonders zur Erzeugung geringmächtiger Gateoxydschichten von etwa 2-10 nM (20 - 100 A) mit bestmöglicher Reproduzierbarkeit und geringsten Prozeßtoleranzen.

Die Oxydation wird beendet, indem die Prozeßgase durch N mittels eines weiteren "soft-pump-down" Schrittes wiederholen. Darauf folgt ein lineares "ramping-down" auf ca. 800 C und unterschiedlich langem Verweilen bei dieser Temperatur. Nun wird über den Spülgaseinlaßstutzen 27 und den -auslaßstutzzen 24 von "low- flow-mode" auf "high-flow-mode unter Einsatzvon $N_2$ umgeschaltet, um das gesamte System rasch auf etwa 300° C, oder, prozeßabhängig, bis auf Raumtemperatur abzukühlen.

Nach Erreichen dieser Temperatur werden die behandelten Halbleiterscheiben 11 mit dem Turntable wieder ausgefahren, bzw. die Reaktionseinheit angehoben und von dem Roboter 54 gegen eine neue Charge ausgetauscht. Der Prozess beginnt nun von vorn.

Infolge des vakuumdicht verschlossenen Reaktionsraumes 8 können auch weitere, bisher mit den bekannten Vertikalvorrichtungen nicht durchführbare Verfahrensvarianten bei der Oxydation ablaufen. So ist es beispielsweise möglich, mit der Vorrichtung auch eine Niederdruckoxydation oder auch eine Niederdruckoxydation unter gleichzeitiger Verdünnung der Restgasatmosphäre mit Inertgas (z.B. $N_2$,Ar,He,Kr,Xe usw.) durchzuführen. Bei beiden Varianten ist eine einwandfreie Kontrolle des Oxydwachstums unter extremen Bedingungen möglich, d.h. es können selbst kleine langzeitkonstante Wachstumsraten bei äußerst geringmächtigen Oxydschichten (20 - 100 Å) erzielt werden, wenn in-situ-Oberflächen angeboten werden.

Durch die Einführung eines äußeren Spülraumes 10, der in "high-flow" und "low-flow" mode betrieben werden kann, ist sichergestellt, daß die Heizkassette 4 den Reaktionsraum 8 nicht contaminieren kann. Es genügt dabei eine Spülung mit wenigen Litern Spülgas pro Minute ("low-flow" mode). Bei Anwendung der high-flow-mode", d.h. Durchfluß großer Mengen Spülgas dagegen ist eine rasche Abkühlung der Heizkassette 4 und somit des gesamten Systems innerhalb kürzester Zeit möglich. Die bisher nicht unterschreitbaren oder üblicherweise eingehaltenen stand-by Temperaturen von 700 - 800 C werden sehr rasch zeitlich linear oder exponentiell bis ca. 300 C und darunter bzw. Raumtemperatur herabgesetzt. (sogen. "schnelle Heizkassette").

Der Turntable 14 rotiert während des gesamten Prozessablaufes langsam, mit ggf. wechselnden Winkelgeschwindigkeiten, mit den Halbleiterscheiben 11 im radialen Gasstrom, der sich zwischen den Halbleiterscheiben verteilt und somit deren gesamte Oberfläche bespült. Auf diese Weise wird ein äußerst gleichmäßiges, reproduzierbares Prozeßergebnis erzielt. Der Turntable 14 besteht vorzugsweise aus Polysilizium, Keramik oder anderen halbleitertauglichen Materialien, wie z.B. SiC oder andere und ist bis weit über 1300 C formstabil, als Scheibe ausgebildet, die ein nach unten ragendes koaxiales Tragrohr 33 aus gleichem Material mit zweifacher Lagerung 34,35 mit innerer 33a und äußerer 22 Kühlung besitzt.

Beispiel 2: Tempern.

Zunächst erfolgt das Beladen des Turntables 14 wie im Beispiel 1 beschrieben.

Das Tempern von Halbleiterscheiben wird in der Vorrichtung, die ein absolut geschlossenes, vertikal angeordnetes Ofensystem darstellt, eindeutig definierte Gaseinlaß- und Gasauslaß-öffnungen besitzt und sowohl Start als auch Beendigung des darin durchgeführten Verfahrens bei Raumtemperatur ermöglicht, in 100 % Reinst-Wasserstoff im Kalt-Heiß-Kalt-Zyklus durchgeführt. Dies ist möglich, da die Vorteile der erfindungsgemäßen Vorrichtung in vorteilhafter Weise eine Prozessführung mit gesichertem Gasaustausch (zunächst wird undefinierte Reinraumluft gegen $N_2$ und anschließend der Stickstoff gegen Reinst-$H_2$ 100 % ausgetauscht) bei Raumtemperatur, Hochrampen auf die gewünschte Tempertemperatur (typisch: 420° - 490° C oder auch höher), prozeßabhängiges Verweilen bei dieser Temperatur und dann definiertes Abkühlen in der 100 % $H_2$ Atmosphäre bis auf Raumtemperatur und anschließend -immer noch in dem geschlossenen System- Austausch dieses 100 % $H_2$ gegen $N_2$ und dann, nach angemessener Spülzeit mit Spülgas Austausch desselben gegen die Reinraumatmosphäre zum Entladen wie bei Beispiel 1.

Beispiel 3: Diffusion, Belegung mit Dotierstoff.

Ein weiter Vorteil der erfindungsgemäßen Vorrichtung ist, erstmalig in Verbindung mit dem "soft-pump-down" Schritt zu einem beliebig vorbestimmbaren Zeitpunkt während des Verfahrens den eindeutig definierten sofortigen Abbruch einer Belegung mit Dotierstoff, d.h. die sofortige Beendigung der Einspeisung des Dotierstoffes in den Reaktionsraum 8 und spontane Absaugung dieses Dotiergasgemisches aus dem Reaktionsraum 8 herbeizuführen. Somit sind auch sehr geringe Dotierungen mit minimalsten Eindringtiefen xj und hohen Schichtwiderstandswerten $R_S$ Ω/0 , d.h. geringste Oberflächenkonzentrationen, realisierbar.

In jedem Falle wird durch die erfindungsgemäß ausgebildete Vorrichtung eine wesentlich bessere Prozeßqualität und Reproduzierbarkeit erreicht. Dazu trägt auch die Ausbildung des inneren Prozeßrohres 1, das als sogen. Injektorrohr ausgebildet ist, bei, weil durch diese Maßnahme das gesamte System von vornherein auf die sogen. "in-cage" Prozeßführung abgestimmt ist, d.h. für alle Prozesse der Oxydation, Temperung, Diffusion/Belegung, Drive-in, Deposition usw. entfallen die sogen. "cage-boats". In diese sind Scheibenträger in geschlossenen Zylindern mit endständigen Abschlußplatten und mehreren Lochreihen in der Zylinderfläche (für den Prozeßgaseintritt) eingearbeitet oder gestellt. Die mit dieser "cage-boats"-Technologie verbundenen Nachteile bei der Prozeßführung, nämlich die festgelegte Position der Halbleiterscheiben relativ zu den Löchern der Lochreihen und die dadurch systembedingte ungleichmäßige Anströmung ist bei der erfindungsgemäß vorgeschlagenen Vorrichtung ausgeschlossen. Die Halbleiterscheiben 11 und die Lochreihen 7 sind nämlich schräg zueinander angeordnet, wobei die Halbleiterscheiben sich relativ dazu und somit auch relativ zu dem Injektionsstrom in einer Rotationsbewegung auf dem Turntable 14 befinden.

Auf diese Weise sind in der Halbleitertechnologie engste Prozeßtoleranzen und bestmögliche Reproduzierbarkeit realisierbar, was sich mit Vorteil bei CVD-Prozessen aller Art einsetzen läßt; denn diese Prozesse sind in außergewöhnlich starkem Maße von den Strömungsverhältnissen im Reaktionsraum 8 und der variierbaren Rotationsgeschwindigkeit des Turntables 14 und dem Reaktionsrohr 1 als "cage-boat" -Ersatz abhängig. Selbstverständlich trägt auch das kleinstmögliche Durchmesserverhältnis Reaktionsrohr 1 / Halbleiterscheibe 11 ($Q_{T/W}$) ≦ 1,3 -typisch 1,26 bis 1,2 und, je nach Durchmesser der Halbleiterscheiben 11, noch kleiner- zu den Vorteilen der mit der Erfindung vorgeschlagenen, vertikal arbeitenden Vorrichtung bei.

STÜCKLISTE

1 - Inneres Prozessrohr
2 - äußeres Prozessrohr
3 - Mantelrohr
4 - Heizkassette
5 - Heizkassettenmantelkühlung
6 - Haube
7 - Lochreihen
8 - Reaktionsraum
9 - Hohlraum, sog. Prozessgaszwischenraum
10 - äußerer ringförmiger Spülraum
11 - Halbleiterscheiben
12 - Scheibenaufnahme
13 - Scheibenträger
14 - Drehtisch = Turn table
15 - Reaktionsraumverschluß-System
16 - Prozessgasvorwärmer
17 - Heizelement (regelbares, scheibenförmiges)
18 - Heizelement
19 - Einlaßstutzen (tangential, für die Mantelkühlung)
20 - Hohlraum
21 - Stützrohr
22 - Kühlraum mit Einlaßstutzen (mit tangentialer Einblasung) und Auslaßstutzen
23 - Tragrohrlagerschale mit integrierter Kühlung
24 - Spülgasauslaßstutzen
25 - Kühlgasauslaßstutzen
26 - Flanschverbindung
27 - Spülgaseinlaßstutzen
28 - Prozessgaseinlaßstutzen
29 - Montagevorrichtung
30 - Prozessgasauslaßstutzen
31 - Wasserkühlungskanal
32 - Luftkühlungskanal
33 - Tragrohr
33 a) Luftkuhlung (für das Tragrohr 33)
34 - Lager
35 - Lager
36 - Schutz-(Kühl-/Absaug)Rohr
37 - Antrieb
38 - Schienensystem
39 - Lager
40 - Rahmen
41 - Gestell
42 - Halteplatte
43 a) oberer Ringflansch
43 b) unterer Ringflansch
44 - Schienensystem
45 - Heizzylinder (innerer, regelbarer)
46 - Heizelement, regelbar
47 - Abschlußplatte
48 - (Stahl- )Mantel
49 - Dichtung, ringförmig (mit Fluidkühlung)
50 - zylindrisches Heizelement
51 - U-profilförmiger Ringflansch
52 - Heizelement

53 - Reinraumtisch
54 - Roboter
55 a) Gebläse mit Filtereinheiten
55 b) Gebläse mit Filtereinheiten
56 - Verschiebeeinrichtung

## Ansprüche

1. Verfahren zur thermischen Behandlung von Halbleitermaterialien bei dem die zu behandelnden Halbleiterscheiben oder dergl. in einem isothermalen, vertikal angeordneten Prozessraum Prozessgasmischungen unterschiedlicher und wechselnder Zusammensetzung und Temperatur ausgesetzt werden, **dadurch gekennzeichnet,** daß man die Prozessgase vor Eintritt in den Prozessraum durch eine Vorwärmzone in einen auf Prozesstemperatur geheizten Vorraum unter leicht erhöhtem Druck von unten nach oben strömen lässt und von diesem Vorraum aus mit Strömumgsumkehr schräg in den Prozessraum in einer Strudelbewegung leitet, wo die zu behandelnden Halbleiterscheiben, schräg zur senkrechten Achse angeordnet, rotierend von den einströmenden Prozessgasen in permanent wechselnden Auftreffwinkeln umspült werden, danach die Prozessgase nach unten wieder aus dem Prozessraum entfernt.

2. Verfahren nach Anspruch 1, **dadurch gekennzeichnet,** daß man die Prozessgase durch schräg gestellte Düsen in eine Strudelbewegung versetzt und durch die Zwischenräume der auf einem Turntable rotierenden, darauf schräg angeordneten Halbleiterscheiben nach unten strömen lässt.

3. Verfahren nach Anspruch 1 und 2, **dadurch gekennzeichnet,** daß man mindestens während der gesamten Verfahrensdauer geringe Mengen inerter Spülgase in einem von den Prozessgasen getrennten, diese umgebenden, äusseren Strom jedoch innerhalb der Wärmequelle in beliebiger Richtung fliessen lässt.

4. Verfahren nach Anspruch 1 bis 3, **dadurch gekennzeichnet,** daß man während der Abkühlphase des Prozessraumes die Mengen der inerten Spülgase stark erhöht.

5. Verfahren nach Anspruch 1 bis 4, **dadurch gekennzeichnet,** daß man während der Abkühlphase einen weiteren Strom grosser Mengen inerter Gase zwischen dem Gehäusemantel und der Wärmequelle hindurchleitet.

6. Verfahren nach Anspruch 1 und einen der folgenden, **dadurch gekennzeichnet,** daß man die Verfahren nach vakuumdichtem Verschließen des Reaktionsraumes gegenüber dem Druck der Atmosphäre bei reduziertem Innendruck als auch erhöhtem Innendruck ablaufen läßt.

7. Verfahren nach Anspruch 1 und einen der folgenden, **dadurch gekennzeichnet,** daß man zur Einstellung niedriger Prozeßstart- und -endtemperaturen bis herab zur Raumtempratur große Mengen Spülgase einsetzt.

8. Verfahren nach Anspruch 1 und einen der folgenden, **dadurch gekennzeichnet,** daß die Prozeßgase zur Vermeidung jedwelcher Abkühlung unter den obersten Kondensationspunkt innerhalb der Vorrichtung zweimal einen Prozeßgasvorwärmer durchströmen und zwar zunächst in einer Aufwärtsbewegung beim Einströmen in einen Hohlraum zwischen dem inneren und dem äußeren Prozeßrohr und beim Ausströmen aus dem Prozeßraum nach Abschluß eines Verfahrens in einer Abwärtsbewegung als Abgase.

9. Vorrichtung zur Durchführung des Verfahrens nach Anspruch 1 bis 8, die einen vertikal angeordneten isothermalen Prozessraum mit einem einseitig offenen Prozessrohr und einer zylindrisch das Prozessrohr umfassenden Heizkassette aufweist, wobei die zu behandelnden Halbleiterscheiben auf einem innerhalb des Prozessraumes befindlichen Träger angeordnet sind, sowie einer in einem das Prozessrohr umfassenden Ringraum vorgesehenen Fluidspülung, **dadurch gekennzeichnet,** daß mehrere Prozessrohre (1,2,3) mit dazwischen verbleibenden Hohlräumen (9,10) vorgesehen sind, das innere Prozessrohr (1) den Reaktionsraum (8) umschließt und in seiner Wandung mit mehreren Verwirbelungsdüsen (7) ausgerüstet ist und ein Drehtisch (14) in dem Reaktionsraum (8) angeordnet ist, der mittels einer Relativbewegung gegenüber dem Prozessrohr (1) ein- und ausfahrbar ist, die Prozessrohre (1,2,3) mit mehreren Heizeinrichtungen umgeben sind, von denen die Heizkassette (4) den Reaktionsraum (1) seitlich und oben umfaßt, während der Heizblock (17) in das Verschlußelement (15) des Reaktionsraumes 8 integriert ist und der Prozessgasvorwärmer (16) den Heizblock (17) außen umfaßt und zentral von der Antriebswelle des Drehtisches (14) durchdrungen ist.

10. Vorrichtung nach Anspruch 8, **dadurch gekennzeichnet,** daß ein Prozeßgasvorwärmer 16 vorgesehen ist.

11. Vorrichtung nach Anspruch 8 und 9, **dadurch gekennzeichnet,** daß sie zur Durchführung von "in-cage"-Prozessen durch die Ausrüstung des inneren Prozeßrohres 8 mit einer oder mehreren Lochreihen 7 als Eintrittsöffnungen für die Prozeßgase eingerichtet ist.

12. Vorrichtung nach Anspruch 8 bis 10, **dadurch gekennzeichnet,** daß der Turntable 14 stationär angeordnet ist, während die Reaktionseinheit nach oben verfahrbar ist.

13. Vorrichtung nach Anspruch 8 bis 10, **dadurch gekennzeichnet,** daß die Reaktionseinheit stationär angeordnet ist, während der Turntable 14 zur Be- und Entladung in Reinraumatmosphäre nach unten und seitlich auf Schienen 56 zu einem Tisch 53 mit einem Roboter 54 verfahrbar ist.

## Fig. 1

## Fig. 2

Fig. 3

Fig. 4

EP 0 385 382 A2

# Fig. 5